# EUROPÄISCHE PATENTSCHRIFT

(11) **EP 3 121 826 B1**
(45) Veröffentlichungstag und Bekanntmachung des Hinweises auf die Patenterteilung: **26.08.2020**
(21) Anmeldenummer: 15177887.5
(22) Anmeldetag: 22.07.2015
(51) Int. Cl.: H01F 27/14, H05K 5/06

(54) **AUFNAHMEVORRICHTUNG ZUR AUFNAHME VON ISOLIERFLÜSSIGKEIT**
RECEPTION DEVICE FOR RECEIVING INSULATING FLUID
DISPOSITIF DE RÊCEPTION DESTINÊ À RECEVOIR UN LIQUIDE ISOLANT

(43) Veröffentlichungstag der Anmeldung: 25.01.2017
(73) Patentinhaber: Siemens Aktiengesellschaft, 80333 München (DE)
(72) Erfinder: REISING, Andreas, 90513 Zirndorf (DE); RUDOLPH, Oliver, 91126 Schwabach (DE)

(56) Entgegenhaltungen:
- EP-A1- 2 571 034
- EP-A1- 2 610 881
- EP-A1- 2 924 231
- WO-A1-2007/009961
- WO-A1-2014/082905
- JP-A- S61 128 506

## Beschreibung

Die Erfindung betrifft eine Aufnahmevorrichtung zur Aufnahme von Isolierflüssigkeit aus einem Kessel eines Transformators oder einer Drossel, umfassend einen Kompensator, der als ein Hohlkörper mit einem veränderbaren Kompensatorvolumen ausgebildet ist und mit einer Kesselöffnung des Kessels verbindbar ist, so dass durch die Kesselöffnung Isolierflüssigkeit zwischen einem Kesselinneren des Kessels und dem Kompensatorvolumen strömen kann.

Die JP S61 128506 A offenbart eine Aufnahmevorrichtung, die aus einem formstabilen Tank sowie aus einem Kompensator mit veränderbarem Innenvolumen besteht. Der Kompensator ist als ein Gummibalg ausgeführt und mit dem Ölraum eines Transformators verbunden. Das Innenvolumen des formstabilen Tanks, das außerhalb des Gummibalgs liegt, ist mit Stickstoff befüllt und mit einem pneumatischen Druckgeber verbunden, so dass der Gummibalg von außen gesteuert und mit Druck beaufschlagt werden kann. Dies erhöht den Öldruck im Inneren des Transformators, so dass dieser für höhere Spannung ausgelegt werden kann. Anstelle eines Gummibalgs kann auch ein Faltenbalg zum Einsatz gelangen, wobei dieser über mechanische Federmittel mit Druck beaufschlagt wird. Darüber hinaus können auch andere mechanische Druckgeber zum Einsatz gelangen.

Die nachveröffentlichte EP 2 924 231 betrifft ebenfalls ein Druckausgleichssystem für einen Transformator. Der Transformator ist zum Einsatz auf dem Meeresboden vorgesehen, wo insbesondere der hohe Wasserdruck problematisch ist. Das in diesem Zusammenhang offenbarte Aufnahmegefäß ist aus zwei Kompensatoren zusammengesetzt, die jeweils als Faltenbalg ausgeführt sind. Der Faltenbalg dient dazu, den Druckunterschied zwischen dem Transformator umgebenden Wasser und dem Öl im Inneren des Transformators nicht zu groß werden zu lassen, so dass ein Bersten des Transformatortanks vermieden ist.

Die EP 2 571 034 A1 beschreibt ebenfalls einen Transformator für Anwendungen auf dem Meeresboden, wobei zum Druckausgleich ineinander geschachtelte Faltenbälge vorgeschlagen werden.

Die EP 261 881 beschreibt auch einen Druckkompensator für Tiefseeeinsätze von Transformatoren. Der Druckkompensator (50) weist die Merkmale des Oberbegriffs von Anspruch 1 auf.

Die Gehäuse von Transformatoren und Drosseln werden häufig mit einer speziellen Isolierflüssigkeit, beispielsweise Isolier- bzw. Transformatorenöl, befüllt, das der elektrischen Isolation und/oder Kühlung der Wicklungen der Transformatoren und Drosseln dient. Insbesondere Temperaturänderungen beim Betrieb der Transformatoren und Drosseln verursachen Volumenänderungen der Isolierflüssigkeit im Gehäuse, die kompensiert werden müssen. Zur Kompensation derartiger Volumenänderungen werden häufig Ausdehnungsgefäße verwendet, die im Falle einer Volumenzunahme der Isolierflüssigkeit eine variable Flüssigkeitsmenge aufnehmen und bei anschließender Volumenabnahme wieder abgeben können.

Bekannte Ausdehnungsgefäße sind zur Aufnahme einer variablen Flüssigkeitsmenge dazu ausgebildet, außer der Isolierflüssigkeit Luft mit einer Umgebung des Gehäuses auszutauschen (zu "atmen"), so dass das aufgenommene Luftvolumen das nicht von Isolierflüssigkeit ausgefüllte Volumen des Ausdehnungsgefäßes einnimmt und für einen Druckausgleich sorgt. Die Luft wird in dem Ausdehnungsgefäß beispielsweise in einem Gummisack gespeichert oder durch eine elastische Membran von der Isolierflüssigkeit getrennt, um zu verhindern, dass Sauerstoff und Feuchtigkeit aus der Luft in die Isolierflüssigkeit übergehen und zu einer schnelleren Alterung und Minderung der Isolierfähigkeit der Isolierflüssigkeit und weiteren Isoliermaterials wie Isolierpapier in dem Gehäuse führen. Jedoch verschließen derartige Ausdehnungsgefäße das Gehäuse nicht vollständig (hermetisch) gegenüber der Umgebungsluft, da durch die Haut eines Gummisacks bzw. durch eine Membran immer eine gewisse Menge Sauerstoff und Feuchtigkeit der Luft in die Isolierflüssigkeit übergeht und diese allmählich beeinträchtigt.

Durch Beeinträchtigungen der Isolierung kann es in seltenen Fällen zur Entstehung eines Lichtbogens im Inneren des flüssigkeitsgefüllten Gehäuses kommen. Durch die dabei entstehende extreme Hitze verdampft Isolierflüssigkeit im Bereich des Lichtbogens schlagartig. Die daraus resultierende starke Volumenvergrößerung bewirkt einen plötzlichen Druckanstieg im Gehäuseinneren. Eine mögliche Folge dieses Druckanstiegs ist das Bersten des Gehäuses, das im ungünstigsten Fall einen Brand zur Folge hat. Um die aus dem hohen Druck resultierenden Belastungen zu beherrschen, sind konstruktive Maßnahmen und ein erhöhter Materialeinsatz von Nöten. Beispielsweise wird dazu ein Druckentlastungsventil eingesetzt, das bei Überdruck geöffnet wird, um den Austritt von Gas und Isolierflüssigkeit aus dem Gehäuse zu ermöglichen, oder das Gehäuse wird durch einen mit einer Berstscheibe versehenen Flansch mit einer Dekompressionskammer verbunden, so dass die Berstscheibe bei Überdruck platzt und die Dekompressionskammer Gas und Isolierflüssigkeit aufnehmen kann.

Der Erfindung liegt die Aufgabe zugrunde, eine verbesserte Aufnahmevorrichtung zur Aufnahme von Isolierflüssigkeit aus einem Kessel eines Transformators oder einer Drossel sowie ein verbessertes Gehäuse eines Transformators oder einer Drossel anzugeben.

Die Aufgabe wird erfindungsgemäß hinsichtlich der Aufnahmevorrichtung durch die Merkmale des Anspruchs 1 und hinsichtlich des Gehäuses durch die Merkmale des Anspruchs 12 gelöst.

Vorteilhafte Ausgestaltungen der Erfindung sind Gegenstand der Unteransprüche.

Eine erfindungsgemäße Aufnahmevorrichtung gemäß Anspruch 1 zur Aufnahme von Isolierflüssigkeit aus einem Kessel eines Transformators oder einer Drossel umfasst einen Kompensator, der als ein Hohlkörper mit einem veränderbaren Kompensatorvolumen ausgebildet ist und mit einer Kesselöffnung des Kessels verbindbar ist, so dass durch die Kesselöffnung Isolierflüssigkeit zwischen einem Kesselinneren des Kessels und dem Kompensatorvolumen strömen kann.

Der Begriff "Kessel" wird hier und im Folgenden allgemein im Sinne eines mit Isolierflüssigkeit befüllten Behälters verwendet und umfasst somit beispielsweise auch mit Isolierflüssigkeit befüllte Kabelanschlusskästen und Schalterkammern.

Der Kompensator ersetzt dabei ein herkömmliches Ausdehnungsgefäß zur Kompensation der Volumenänderungen der Isolierflüssigkeit. Gegenüber einem herkömmlichen Ausdehnungsgefäß mit einem Gummisack oder einer Membran wird das Volumen zur Aufnahme der Isolierflüssigkeit nicht durch Luftzufuhr und - abfuhr an die Menge der aufzunehmenden Isolierflüssigkeit angepasst, sondern durch eine Änderung des Kompensatorvolumens selbst. Dadurch kann der Kompensator gegenüber der Umgebungsluft hermetisch verschlossen werden, so dass die Isolierflüssigkeit nicht durch Sauerstoff und Feuchtigkeit aus der Umgebungsluft beeinträchtigt wird.

Darüber hinaus kann ein Kompensator eine relativ große Querschnittsfläche aufweisen und daher über eine entsprechend große Kesselöffnung mit dem Kesselinneren des Kessels verbunden sein, während ein herkömmliches Ausdehnungsgefäß durch ein Rohr mit einer vergleichsweise kleinen Querschnittsfläche mit dem Kesselinneren verbunden ist. Die große Querschnittsfläche und große Kesselöffnung ermöglichen eine schnelle Reaktion auf und Kompensation von Volumenänderungen der Isolierflüssigkeit. Dadurch können insbesondere durch Lichtbögen in dem Kesselinneren verursachte schlagartige Volumenänderungen der Isolierflüssigkeit und dadurch bedingte Druckanstiege schneller und effektiver kompensiert werden als mittels herkömmlicher Ausdehnungsgefäße.

Die Erfindung sieht einen Verdrängungsbehälter vor, der im Innern des Kompensators und gegenüber dem Kompensator hermetisch verschlossen angeordnet ist. Vorzugsweise ist der Verdrängungsbehälter als ein Ausdehnungsgefäß zur Aufnahme von Isolierflüssigkeit durch die Kesselöffnung aus dem Kesselinneren ausgebildet.

Die Erfindung sieht ferner vor, dass der Verdrängungsbehälter einen Verdrängungsbehälterflansch aufweist, der dazu ausgebildet ist, den Verdrängungsbehälter wahlweise eine Kompensatoröffnung verschließend an dem Kompensator lösbar zu befestigen oder, anstatt des Kompensators, die Kesselöffnung verschließend an dem Kessel lösbar zu befestigen, so dass im letzteren Fall durch die Kesselöffnung Isolierflüssigkeit zwischen dem Kesselinneren und dem Inneren des Verdrängungsbehälters strömen kann. Vorzugsweise weist der Kompensator dabei einen ersten Kompensatorflansch auf, an dem der Verdrängungsbehälterflansch die Kompensatoröffnung verschließend lösbar befestigbar ist. Ferner weist der Kompensator vorzugsweise einen zweiten Kompensatorflansch auf, der dazu ausgebildet ist, den Kompensator die Kesselöffnung des Kessels verschließend lösbar an dem Kessel zu befestigen.

Dadurch können in einfacher Weise der Verdrängungsbehälter wahlweise an dem Kessel oder dem Kompensator und der Kompensator an dem Kessel lösbar befestigt werden.

Erfindungsgemäß kann in Problemfällen, in denen der Kompensator, beispielsweise durch eine Beschädigung, nicht funktionsfähig ist, eine Wiederherstellung der Funktionsfähigkeit der Aufnahmevorrichtung durch eine Reparatur oder Ersetzung des Kompensators und damit eine Wiederinbetriebnahme des Transformators bzw. der Drossel unter Umständen mit einem hohen Zeit- und/oder Kostenaufwand verbunden ist. Um diesem Problem zu begegnen sehen die vorgenannten Ausgestaltungen der Erfindung vor, die Aufnahmevorrichtung um einen Verdrängungsbehälter zu erweitern, der wahlweise im Innern des Verdrängungsbehälters oder anstelle des Kompensators mit der Kesselöffnung verbindbar ist und vorzugsweise als ein Ausdehnungsgefäß ausgebildet ist. Dies ermöglicht vorteilhaft, den Kompensator in Problemfällen, in denen er nicht funktionsfähig ist, durch den Verdrängungsbehälter zu ersetzen, so dass Isolierflüssigkeit statt durch den Kompensator durch den Verdrängungsbehälter aufgenommen werden kann, so dass der Transformator bzw. die Drossel ohne den Kompensator weiterbetrieben werden kann. Insbesondere wenn der Verdrängungsbehälter als ein Ausdehnungsgefäß ausgebildet ist, kann dadurch ein Zeitraum bis zu einer Reparatur oder einem Austausch des Kompensators überbrückt werden, ohne den Betrieb des Transformators bzw. der Drossel lange unterbrechen zu müssen. Gegebenenfalls braucht der Kompensator in solchen Fällen auch gar nicht repariert oder ausgetauscht werden, wenn eine dauerhafte Fortsetzung des Betriebs des Transformators bzw. der Drossel mit dem Verdrängungsbehälter statt dem Kompensator akzeptabel ist.

Es kann auch eine Rückhalte- und Freigabevorrichtung vorgesehen sein, welche eine Vergrößerung des Kompensatorvolumens verhindert, solange ein Innendruck in dem Kompensator einen Druckschwellenwert nicht überschreitet, und eine Vergrößerung des Kompensatorvolumens freigibt, wenn der Innendruck in dem Kompensator den Druckschwellenwert überschreitet.

Diese nicht zur Erfindung gehörende Variante ist speziell auf die Kompensation eines durch einen Lichtbogen in dem Kessel verursachten schlagartigen Druckanstiegs in dem Kessel gerichtet. Durch die Rückhalte- und Freigabevorrichtung wird dabei eine Vergrößerung des Kompensatorvolumens erst bei dem Überschreiten eines Druckschwellenwerts zugelassen, der einem bei einem Lichtbogen in dem Kessel zu erwartenden Überdruck entspricht. In einem Nennbetrieb, in dem der Druck in dem Kessel den Druckschwellenwert nicht überschreitet, hat der Kompensator keine Funktion.

Vorzugsweise ist im Rahmen der Erfindgung in dem Verdrängungsbehälter ein Gasbehälter mit einem veränderbaren Gasbehältervolumen angeordnet, und der Verdrängungsbehälter weist eine verschließbare Gasöffnung zu dem Gasbehältervolumen auf, so dass bei geöffneter Gasöffnung Gas zwischen dem Gasbehältervolumen und der Umgebung des Kessels strömen kann, wenn der Verdrängungsbehälter mit der Kesselöffnung verbunden ist. Der Gasbehälter ist dabei beispielsweise als ein Gummisack ausgebildet.Der Gasbehälter ermöglicht dabei vorteilhaft einen Druckausgleich bei der Zufuhr von Isolierflüssigkeit in den Verdrängungsbehälter bzw. der Abfuhr von Isolierflüssigkeit aus dem Verdrängungsbehälter durch ein "Atmen" des Verdrängungsbehälters mittels des Gasbehälters durch die Gasöffnung. Die Verschließbarkeit der Gasöffnung ermöglicht es, ein Eintreten von Isolierflüssigkeit in den Gasbehälter zu verhindern, wenn der Verdrängungsbehälter in dem Kompensator angeordnet ist und der Kompensator die Kesselöffnung verschließt. Die Ausbildung des Gasbehälters als ein Gummisack ist eine einfache und bewährte Ausgestaltung des Gasbehälters zur Aufnahme eines veränderbaren Gasvolumens.

Ferner weist die Gasöffnung beispielsweise einen Gasentfeuchteranschluss für einen Gasentfeuchter auf, oder die Gasöffnung ist mit einer semipermeablen Membran, die für Gas aber nicht für Flüssigkeit durchlässig ist, verschlossen.

Dadurch kann vorteilhaft Gas, das in den Gasbehälter eintritt, entfeuchtet werden, so dass weniger Feuchtigkeit aus in dem Gasbehälter enthaltenem Gas in die Isolierflüssigkeit übergehen kann.

Des Weiteren weist der Verdrängungsbehälter vorzugsweise einen Buchholzrelaisanschluss für ein Buchholzrelais auf.

Dadurch kann der Betrieb eines Transformators bzw. einer Drossel bei der Verwendung des Verdrängungsbehälters zur Kompensation von Volumenänderungen der Isolierflüssigkeit durch ein Buchholzrelais geschützt werden.

Eine weitere Ausgestaltung der Erfindung sieht vor, dass der Verdrängungsbehälter vakuumfest ausgebildet ist.

Dadurch wird der Verdrängungsbehälter vorteilhaft gegen eine Beschädigung durch einen geringen Druck geschützt.

Eine weitere Ausgestaltung der Erfindung sieht vor, dass der Verdrängungsbehälter als ein topfähnlicher Hohlkörper ausgebildet ist.

Die topfähnliche Ausbildung des Verdrängungsbehälters ermöglicht vorteilhaft, das Innere des Verdrängungsbehälters als Stauraum zur Lagerung von Ersatz- und Reservekomponenten wie Isolierelementen, einem Ersatzgummisack, einem Ersatzbuchholzrelais, Berstscheiben und/oder Überdruckschutzventilen zu nutzen, wenn der Verdrängungsbehälter in dem Kompensator angeordnet ist.

Eine weitere Ausgestaltung der Erfindung sieht vor, dass der Verdrängungsbehälter aus einem metallischen Werkstoff gefertigt ist.

Die Fertigung des Verdrängungsbehälters aus einem metallischen Werkstoff ermöglicht vorteilhaft eine stabile Ausbildung des Verdrängungsbehälters.

Eine weitere Ausgestaltung der Erfindung sieht vor, dass der Kompensator zur Ausbildung des veränderbaren Kompensatorvolumens einen Faltenbalg aufweist.

Durch einen Faltenbalg kann vorteilhaft in einfacher Weise ein an eine aufzunehmende Menge von Isolierflüssigkeit anpassbares, veränderbares Kompensatorvolumen des Kompensators realisiert werden.

Eine Weitergestaltung der vorgenannten Ausgestaltung der Erfindung sieht wenigstens zwei Kompensatoren vor, die sich hinsichtlich des Härtegrades ihrer Faltenbälge voneinander unterscheiden.

Unter dem Härtegrad eines Faltenbalgs wird dabei ein Widerstand verstanden, den der Faltenbalg seiner Längenänderung entgegensetzt. Durch eine geeignete Wahl der Härtegrade und Ausbildung der Kompensatoren kann dadurch beispielsweise erreicht werden, dass durch wenigstens einen Kompensator vornehmlich thermisch verursachte Volumenänderungen der Isolierflüssigkeit kompensiert werden, die in einem Normalbetrieb des Transformators oder der Drossel auftreten, während durch wenigstens einen weiteren Kompensator mit einem größeren Härtegrad vornehmlich schlagartige Volumenänderungen der Isolierflüssigkeit kompensiert werden, die durch Lichtbögen in dem Kessel verursacht werden.

Ein erfindungsgemäßes Gehäuse eines Transformators oder einer Drossel umfasst einen Kessel mit einer Kesselöffnung und eine erfindungsgemäße Aufnahmevorrichtung zur Aufnahme von Isolierflüssigkeit aus dem Kessel mit den oben genannten Vorteilen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: schematisch eine Seitenansicht eines ersten Ausführungsbeispiels eines Gehäuses eines Transformators oder einer Drossel,
- FIG 2: schematisch eine Seitenansicht eines zweiten Ausführungsbeispiels eines Gehäuses eines Transformators oder einer Drossel,
- FIG 3: schematisch eine Seitenansicht eines dritten Ausführungsbeispiels eines Gehäuses eines Transformators oder einer Drossel,
- FIG 4: eine schematische Schnittdarstellung eines erfindungsgemässen vierten Ausführungsbeispiels eines Gehäuses eines Transformators oder einer Drossel in einem Kompensatorbetrieb,
- FIG 5: eine perspektivische Darstellung des in Figur 4 dargestellten Gehäuses in dem Kompensatorbetrieb,
- FIG 6: eine perspektivische Schnittdarstellung des in Figur 4 dargestellten Gehäuses in dem Kompensatorbetrieb,
- FIG 7: eine schematische Schnittdarstellung des in Figur 4 dargestellten Gehäuses in einem Ausdehnungsgefäßbetrieb,
- FIG 8: eine perspektivische Darstellung des in Figur 4 dargestellten Gehäuses in dem Ausdehnungsgefäßbetrieb,
- FIG 9: eine perspektivische Schnittdarstellung des in Figur 4 dargestellten Gehäuses in dem Ausdehnungsgefäßbetrieb,
- FIG 10: schematisch eine Seitenansicht eines fünften Ausführungsbeispiels eines Gehäuses eines Transformators oder einer Drossel in einem Nennbetrieb,
- FIG 11: schematisch eine Seitenansicht des in Figur 10 dargestellten Gehäuses bei einem Überdruck in dem Gehäuse,
- FIG 12: schematisch eine Seitenansicht eines sechsten Ausführungsbeispiels eines Gehäuses eines Transformators oder einer Drossel,
- FIG 13: schematisch eine Seitenansicht eines siebten Ausführungsbeispiels eines Gehäuses eines Transformators oder einer Drossel,
- FIG 14: schematisch eine Seitenansicht eines achten Ausführungsbeispiels eines Gehäuses eines Transformators oder einer Drossel in einem Nennbetrieb,
- FIG 15: schematisch eine Seitenansicht des in Figur 14 dargestellten Gehäuses bei einem Überdruck in dem Gehäuse, und
- FIG 16: schematisch eine Seitenansicht eines neunten Ausführungsbeispiels eines Gehäuses eines Transformators oder einer Drossel.

Einander entsprechende Teile sind in allen Figuren mit den gleichen Bezugszeichen versehen.

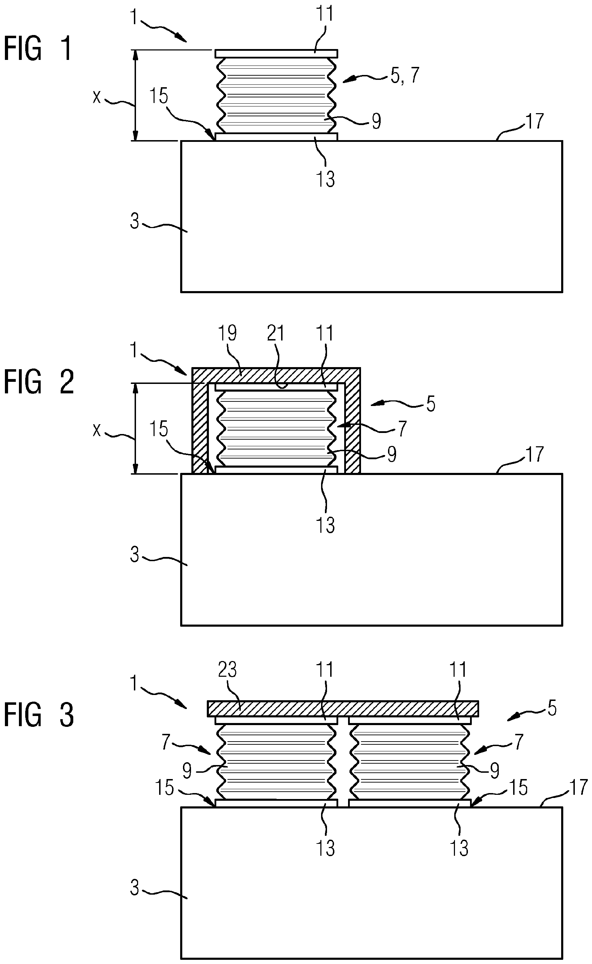

Figur 1 zeigt schematisch eine Seitenansicht eines ersten Ausführungsbeispiels eines Gehäuses 1 eines Transformators oder einer Drossel. Das Gehäuse 1 umfasst einen Kessel 3 und ein erstes Ausführungsbeispiel einer Aufnahmevorrichtung 5 zur Aufnahme von Isolierflüssigkeit aus dem Kessel 3.

Die Aufnahmevorrichtung 5 ist als ein Kompensator 7 ausgebildet, der einen Faltenbalg 9 und zwei Kompensatorflansche 11, 13 aufweist. Ein erster Kompensatorflansch 11 ist an einem ersten, von dem Kessel 3 abgewandten Ende des Faltenbalgs 9 angeordnet und als ein Blindflansch zum Verschließen des Kompensators 7 ausgebildet. Der zweite Kompensatorflansch 13 ist an einem zweiten, dem Kessel 3 zugewandten Ende des Faltenbalgs 9 angeordnet und dazu ausgebildet, den Kompensator 7 an dem Kessel 3 zu befestigen, so dass eine Kesselöffnung 15 des Kessels 3 hermetisch verschlossen wird und durch die Kesselöffnung 15 Isolierflüssigkeit aus dem Kessel 3 in den Kompensator 7 und aus dem Kompensator 7 in den Kessel 3 strömen kann. Die Kesselöffnung 15 befindet sich in einem Kesseldeckel 17 des Kessels 3. Der Kompensator 7 kann lösbar, beispielsweise mittels Schraubverbindungen, oder fest, beispielsweise durch eine Schweißverbindung, an dem Kessel 3 befestigt sein. Im Fall einer festen Schweißverbindung kann der zweite Kompensatorflansch 13 entfallen.

Durch den Faltenbalg 9 weist der Kompensator 7 eine veränderbare Längsausdehnung x und ein veränderbares Kompensatorvolumen auf, so dass er eine variable Menge von Isolierflüssigkeit aufnehmen kann. Dadurch können Volumenänderungen der Isolierflüssigkeit in dem Kessel 3 kompensiert werden. Der Kompensator 7 ist dazu ausgelegt, wenigstens in einem Normalbetrieb des Transformators oder der Drossel zu erwartende thermisch bedingte Volumenänderungen der Isolierflüssigkeit zu kompensieren. Ferner kann der Kompensator 7 dazu ausgelegt sein, zusätzlich auch durch einen Lichtbogen im Kessel 3 verursachte schlagartige Ausdehnungen von Isolierflüssigkeit und damit verbundene Druckanstiege innerhalb des Kessels 3 zu kompensieren. Die Auslegung des Kompensators 7 wird durch eine entsprechende Auslegung eines maximalen Kompensatorvolumens erreicht, die wiederum einer maximalen Längsausdehnung x des Kompensators 7 entspricht.

Der Faltenbalg 9 ist beispielsweise aus einem metallischen Werkstoff oder einem Gummi gefertigt.

Statt den Kompensator 7 direkt wie in Figur 1 an dem Kessel 3 zu befestigen, kann der Kompensator 7 auch in einem Abstand von dem Kessel 3 angeordnet sein und durch eine starre Verbindung, beispielsweise eine Rohrleitung, oder eine flexible Verbindung, beispielsweise einen Verbindungsschlauch, mit dem Kessel 3 verbunden sein, so dass Isolierflüssigkeit aus dem Kessel 3 in den Kompensator 7 und aus dem Kompensator 7 in den Kessel 3 strömen kann. Ferner kann der Kompensator 7 statt mittels des ersten Kompensatorflansches 11 auch durch einen gewölbten Deckelbereich verschlossen sein.

Figur 2 zeigt schematisch eine Seitenansicht eines zweiten Ausführungsbeispiels eines Gehäuses 1 eines Transformators oder einer Drossel. Das Gehäuse 1 umfasst einen Kessel 3 und ein zweites Ausführungsbeispiel einer Aufnahmevorrichtung 5 zur Aufnahme von Isolierflüssigkeit aus dem Kessel 3. Dieses Ausführungsbeispiel unterscheidet sich von dem in Figur 1 dargestellten ersten Ausführungsbeispiel nur dadurch, dass die Aufnahmevorrichtung 5 einen Kompensatorrahmen 19 aufweist, der auf dem Kesseldeckel 17 des Kessels 3 montiert ist und einen Anschlag 21 für den ersten Kompensatorflansch 11 umfasst, so dass er die maximale Längsausdehnung x des Kompensators 7 begrenzt. Dadurch kann vorteilhaft eine Überdehnung des Faltenbalgs 9 verhindert werden, die den Faltenbalg 9 beschädigen und die Betriebssicherheit des Kompensators 7 gefährden kann.

Figur 3 zeigt schematisch eine Seitenansicht eines dritten Ausführungsbeispiels eines Gehäuses 1 eines Transformators oder einer Drossel. Das Gehäuse 1 umfasst einen Kessel 3 und ein drittes Ausführungsbeispiel einer Aufnahmevorrichtung 5 zur Aufnahme von Isolierflüssigkeit aus dem Kessel 3. Dieses Ausführungsbeispiel unterscheidet sich von dem in Figur 1 dargestellten ersten Ausführungsbeispiel im Wesentlichen dadurch, dass die Aufnahmevorrichtung 5 zwei Kompensatoren 7 statt nur einen Kompensator 7 aufweist. Jeder der beiden Kompensatoren 7 ist prinzipiell wie der Kompensator 7 des in Figur 1 dargestellten ersten Ausführungsbeispiels ausgebildet.

Durch Verwendung mehrerer Kompensatoren 7 kann die Kompensation von Volumenänderungen der Isolierflüssigkeit auf mehrere Kompensatoren 7 verteilt werden, so dass die einzelnen Kompensatoren 7 eine geringere Kapazität aufzuweisen brauchen als der Kompensator 7 einer Aufnahmevorrichtung 5 mit nur einem Kompensator 7. Durch Lichtbögen verursachte schlagartige Volumenänderungen der Isolierflüssigkeit erzeugen ferner lokale Druckschwankungen, so dass es vorteilhaft ist, mehrere Kompensatoren 7 über die Ausdehnung des Kessels zu verteilen, um derartige lokale Volumen- und Druckänderungen möglichst effektiv zu kompensieren.

Die Verwendung mehrerer Kompensatoren 7 ermöglicht noch weitere vorteilhafte Ausgestaltungen der Erfindung. So können gleichartige Kompensatoren 7 beispielsweise wie in Figur 3 dargestellt mittels einer Koppelungsplatte 23, die die ersten Kompensatorflansche 11 dieser Kompensatoren 7 miteinander verbindet, miteinander gekoppelt werden, um Belastungen gleichmäßig auf diese Kompensatoren 7 zu verteilen, so dass keiner dieser Kompensatoren 7 übermäßig belastet wird. Ferner können auch Kompensatoren 7 eingesetzt werden, die sich hinsichtlich des Härtegrades ihrer Faltenbälge 9 voneinander unterscheiden. Unter dem Härtegrad eines Faltenbalgs 9 wird dabei ein Widerstand verstanden, den der Faltenbalg 9 seiner Längenänderung entgegensetzt. Beispielsweise weist wenigstens ein erster Kompensator 7 einen Faltenbalg 9 mit einem ersten Härtegrad auf und wenigstens ein zweiter Kompensator 7 weist einen Faltenbalg 9 mit einem zweiten Härtegrad auf, der größer als der erste Härtegrad ist. Durch eine geeignete Wahl der Härtegrade und Ausbildung der Kompensatoren 7 kann dadurch erreicht werden, dass durch die ersten Kompensatoren 7 vornehmlich thermisch verursachte Volumenänderungen der Isolierflüssigkeit kompensiert werden, die in einem Normalbetrieb des Transformators oder der Drossel auftreten, während durch die zweiten Kompensatoren 7 vornehmlich schlagartige Volumenänderungen der Isolierflüssigkeit kompensiert werden, die durch Lichtbögen in dem Kessel 3 verursacht werden.

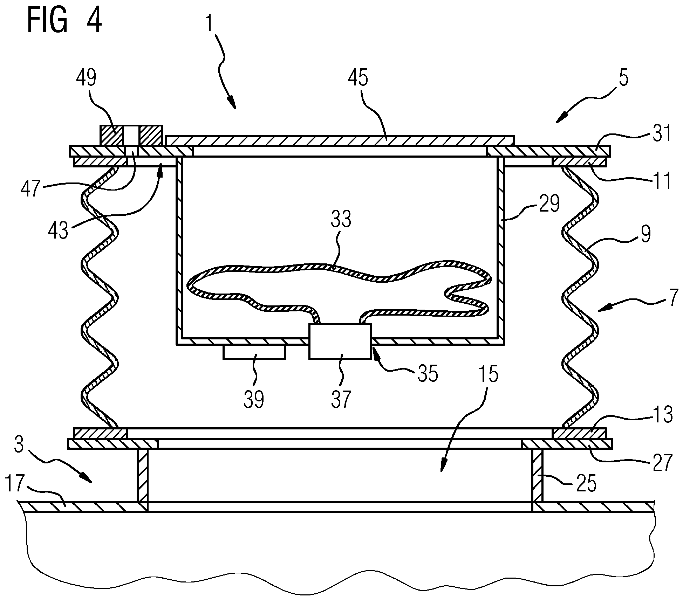

Die Figuren 4 bis 9 zeigen ein erfindungsgemässes viertes Ausführungsbeispiel eines Gehäuses 1 eines Transformators oder einer Drossel. Das Gehäuse 1 umfasst einen Kessel 3 und ein erfindungsgemässes viertes Ausführungsbeispiel einer Aufnahmevorrichtung 5 zur Aufnahme von Isolierflüssigkeit aus dem Kessel 3.

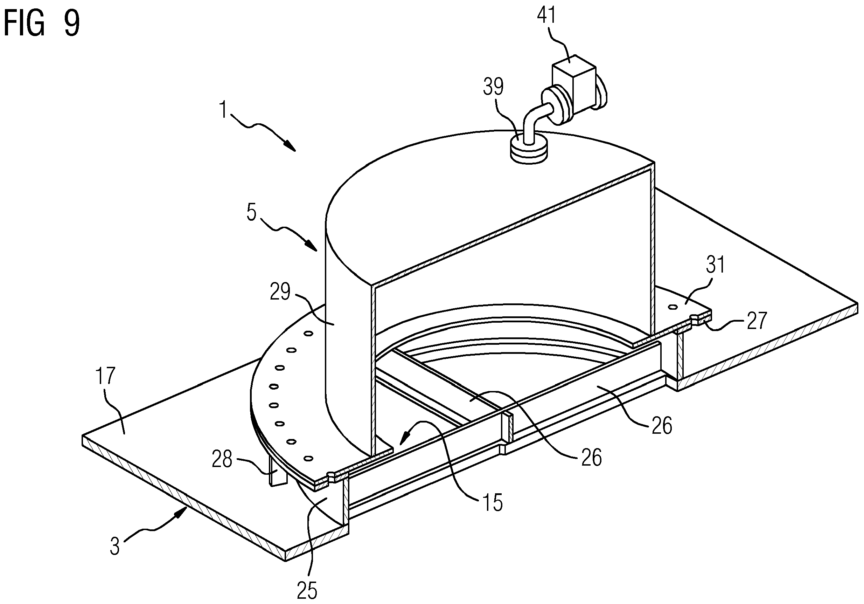

Von dem Kessel 3 ist in den Figuren 4 bis 9 jeweils nur ein Ausschnitt eines Kesseldeckels 17 in dem Bereich einer Kesselöffnung 15 des Kessels 3 dargestellt. Die Kesselöffnung 15 ist von einem Kesselkragen 25 umgeben. Der Kesselkragen 25 weist einen Kragenflansch 27 zur Befestigung der Aufnahmevorrichtung 5 auf. Optional sind zur Erhöhung der Steifigkeit des Kesselkragens 25 verschiedene Bereiche einer Innenoberfläche des Kesselkragens 25 durch Kragenversteifungselemente 26 miteinander verbunden, beispielsweise durch Kragenversteifungselemente 26, die eine rechtwinklige Kreuzstruktur (siehe Figur 9) bilden. Ferner ist der Kragenflansch 27 optional durch zwischen ihm und dem Kesseldeckel 17 verlaufende Stützelemente 28 an dem Kesseldeckel 17 abgestützt.

Die Aufnahmevorrichtung 5 umfasst einen Kompensator 7 und einen Verdrängungsbehälter 29. Die Aufnahmevorrichtung 5 ist dazu ausgebildet, wahlweise in einem von zwei verschiedenen Betriebsmodi betrieben zu werden. Im Folgenden wird ein erster Betriebsmodus als Kompensatorbetrieb bezeichnet und der zweite Betriebsmodus wird als Ausdehnungsgefäßbetrieb bezeichnet.

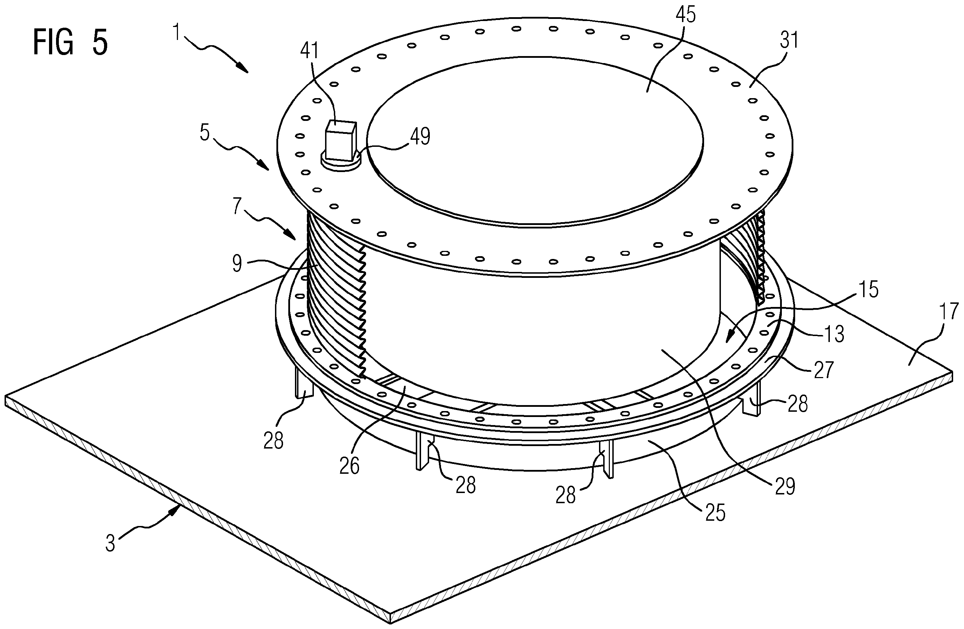

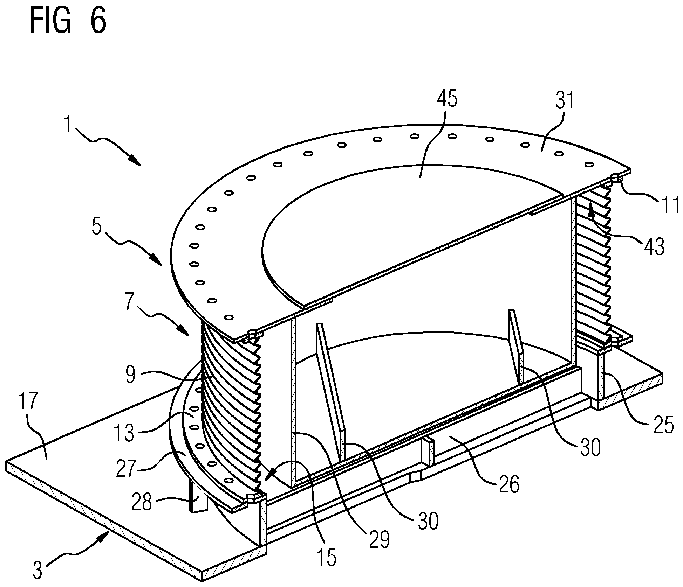

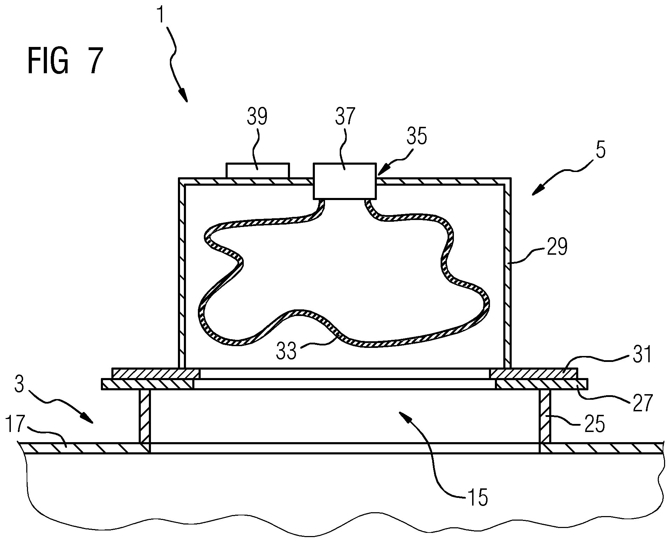

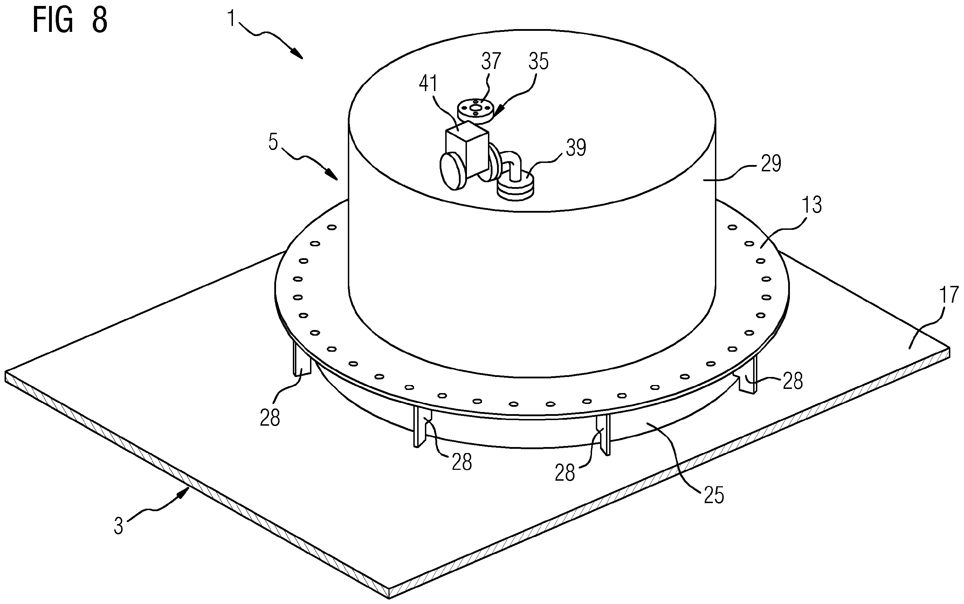

Die Figuren 4 bis 6 zeigen die Aufnahmevorrichtung 5 in dem Kompensatorbetrieb, wobei der Faltenbalg 9 des Kompensators 7 in Figur 5 aufgebrochen dargestellt ist, um das Kompensatorinnere sichtbar zu machen. Die Figuren 7 bis 9 zeigen die Aufnahmevorrichtung 5 in dem Ausdehnungsgefäßbetrieb. Dabei zeigen die Figuren 4 und 7 jeweils eine schematische Schnittdarstellung des Gehäuses 1, die Figuren 5 und 8 zeigen jeweils eine perspektivische Darstellung des Gehäuses 1, und die Figuren 6 und 9 zeigen jeweils eine perspektivische Schnittdarstellung des Gehäuses 1.

Wie die Kompensatoren 7 der in den Figuren 1 bis 3 dargestellten Ausführungsbeispiele umfasst der Kompensator 7 einen Faltenbalg 9, der einen ersten Kompensatorflansch 11 und einen zweiten Kompensatorflansch 13 miteinander verbindet. Im Unterschied zu den Kompensatoren 7 der in den Figuren 1 bis 3 dargestellten Ausführungsbeispiele sind beide Kompensatorflansche 11, 13 ringförmig ausgebildet.

Der Verdrängungsbehälter 29 ist als ein im Wesentlichen zylindrischer, topfähnlicher und vakuumfester Hohlkörper ausgebildet und aus einem metallischen Werkstoff gefertigt. Alternativ kann auch der Verdrängungsbehälter 29 als ein Kompensator 7 ausgebildet sein. Ein Rand des Verdrängungsbehälters 29 ist als ein Verdrängungsbehälterflansch 31 ausgebildet.

In dem Verdrängungsbehälter 29 ist ein Gasbehälter 33 mit einem veränderbaren Gasbehältervolumen angeordnet, der als ein Gummisack ausgebildet ist. Der Verdrängungsbehälter 29 weist in seinem Boden eine verschließbare Gasöffnung 35 zu dem Gasbehältervolumen auf. Die Gasöffnung 35 ist beispielsweise durch einen Schieber, ein Ventil oder eine Verschlusskappe verschließbar. Ferner weist die Gasöffnung 35 einen Gasentfeuchteranschluss 37 für einen Gasentfeuchter auf. Des Weiteren weist der Verdrängungsbehälter 29 an seinem Boden einen verschließbaren Buchholzrelaisanschluss 39 für ein Buchholzrelais 41 auf. Optional sind zur Erhöhung der Steifigkeit des Verdrängungsbehälters 29 verschiedene Bereiche einer Innenoberfläche des Verdrängungsbehälters 29 durch Verstrebungselemente 30 (siehe Figur 6) miteinander verbunden.

In dem Kompensatorbetrieb (siehe Figuren 4 bis 6) ist der zweite Kompensatorflansch 13 des Kompensators 7 mit dem Kragenflansch 27 des Kesselkragens 25 verbunden, so dass die Kesselöffnung 15 hermetisch verschlossen ist und durch die Kesselöffnung 15 Isolierflüssigkeit bei einer Volumenzunahme der Isolierflüssigkeit aus dem Kessel 3 in den Kompensator 7 und bei einer Volumenabnahme der Isolierflüssigkeit aus dem Kompensator 7 in den Kessel 3 strömen kann. Der Verdrängungsbehälter 29 ist in dem Kompensatorbetrieb in dem Kompensator 7 angeordnet, wobei der Verdrängungsbehälterflansch 31 mit dem ersten Kompensatorflansch 11 lösbar verbunden ist, wobei eine dem Boden des Verdrängungsbehälters 29 zugewandte Oberfläche des Verdrängungsbehälterflansches 31 an dem ersten Kompensatorflansch 11 anliegt. Die Gasöffnung 35 und der Buchholzrelaisanschluss 39 des Verdrängungsbehälters 29 sind dabei verschlossen, so dass der Verdrängungsbehälter 29 eine von dem Kessel 3 abgewandte Kompensatoröffnung 43 des Kompensators 7 hermetisch verschließt. Der Verdrängungsbehälter 29 ist durch einen als ein Blindflansch ausgebildeten Verschließflansch 45 verschlossen, der mit dem Verdrängungsbehälterflansch 31 verbunden ist, wobei er mit einem Randbereich an einer von dem Boden abgewandten Oberfläche des Verdrängungsbehälterflansches 31 anliegt. Der Verdrängungsbehälterflansch 31 weist außerdem eine Flanschöffnung 47 auf, die in dem Kompensatorbetrieb zu dem Kompensatorvolumen führt. Über der Flanschöffnung 47 wird in dem Kompensatorbetrieb an dem Verdrängungsbehälterflansch 31 ein Anschlussflansch 49 zum Anschluss eines Buchholzrelais 41 montiert. Das Innere des Verdrängungsbehälters 29 kann in dem Kompensatorbetrieb vorteilhaft als Stauraum zur Lagerung von Ersatz- und Reservekomponenten wie Isolierelementen, einem Ersatzgummisack, einem Ersatzbuchholzrelais und/oder Überdruckschutzventilen genutzt werden.

In dem Ausdehnungsgefäßbetrieb (siehe Figuren 7 bis 9) wird statt des Kompensators 7 der Verdrängungsbehälter 29 über der Kesselöffnung 15 an dem Kessel 3 befestigt, so dass durch die Kesselöffnung 15 Isolierflüssigkeit bei einer Volumenzunahme der Isolierflüssigkeit aus dem Kessel 3 in den Verdrängungsbehälter 29 und bei einer Volumenabnahme der Isolierflüssigkeit aus dem Verdrängungsbehälter 29 in den Kessel 3 strömen kann. Dazu wird der Verdrängungsbehälterflansch 31 mit dem Kragenflansch 27 verbunden, so dass eine von dem Boden abgewandte Oberfläche des Verdrängungsbehälterflansches 31 an dem Kragenflansch 27 anliegt. Die Flanschöffnung 47 ist in dem Ausdehnungsgefäßbetrieb durch den Kragenflansch 27 verschlossen. Die Gasöffnung 35 wird in dem Ausdehnungsgefäßbetrieb geöffnet, so dass der Gasbehälter 33 "atmen" kann, d. h., dass durch die Gasöffnung 35 Gas zwischen einer Umgebung des Gehäuses 1 und dem Gasbehältervolumen des Gasbehälters 33 strömen kann. Ferner wird in dem Ausdehnungsgefäßbetrieb an dem Gasentfeuchteranschluss 37 ein (nicht dargestellter) Gasentfeuchter zur Entfeuchtung des durch die Gasöffnung 35 in den Gasbehälter 33 strömenden Gases angeschlossen. Auch der Buchholzrelaisanschluss 39 wird in dem Ausdehnungsgefäßbetrieb geöffnet und an den Buchholzrelaisanschluss 39 wird ein Buchholzrelais 41 angeschlossen.

Die Aufnahmevorrichtung 5 wird normalerweise in dem Kompensatorbetrieb betrieben. Der Ausdehnungsgefäßbetrieb ist vornehmlich für Problemfälle vorgesehen, in denen die Funktionsfähigkeit des Kompensators 7 beeinträchtigt ist, beispielsweise weil der Kompensator 7 beschädigt ist. Um von dem Kompensatorbetrieb zu dem Ausdehnungsgefäßbetrieb zu wechseln, wird zunächst der Kompensator 7 von dem Kessel 3 abmontiert, wobei der zweite Kompensatorflansch 13 von dem Kragenflansch 27 gelöst wird. Anschließend wird der Verdrängungsbehälter 29 von dem Kompensator 7 getrennt, wobei der Verdrängungsbehälterflansch 31 von dem ersten Kompensatorflansch 11, dem Verschließflansch 45 und dem Anschlussflansch 49 gelöst wird. Danach wird der Verdrängungsbehälter 29 an dem Kessel 3 befestigt, wobei der Verdrängungsbehälterflansch 31 mit dem Kragenflansch 27 verbunden wird. Ferner werden für den Ausdehnungsgefäßbetrieb die Gasöffnung 35 und der Buchholzrelaisanschluss 39 geöffnet, an den Gasentfeuchteranschluss 37 wird ein Gasentfeuchter angeschlossen und an den Buchholzrelaisanschluss 39 wird ein Buchholzrelais 41 angeschlossen. In dem Kompensatorbetrieb verschließt der Verdrängungsbehälter 29 den Kompensator 7 und verdrängt Isolierflüssigkeit aus dem Kompensator 7. In dem Ausdehnungsgefäßbetrieb wirkt der Verdrängungsbehälter 29 wie ein übliches Ausdehnungsgefäß.

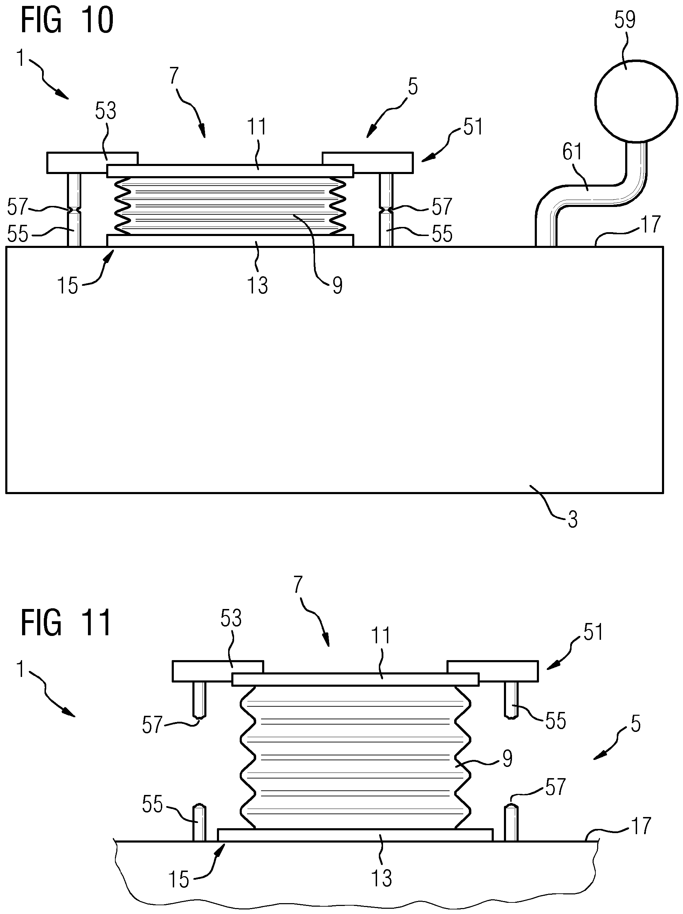

Die Figuren 10 bis 16 zeigen jeweils schematische Seitenansichten weiterer Ausführungsbeispiele eines Gehäuses 1 eines Transformators oder einer Drossel, wobei das Gehäuse 1 jeweils einen Kessel 3 und eine Aufnahmevorrichtung 5 umfasst. Die Aufnahmevorrichtung 5 weist jeweils einen Kompensator 7 auf, der wie der Kompensator 7 des in Figur 1 dargestellten Ausführungsbeispiels gestaltet ist. Zusätzlich zu dem Kompensator 7 weist die Aufnahmevorrichtung 5 jeweils eine Rückhalte- und Freigabevorrichtung 51 auf, die ein Entfalten des Faltenbalgs 9 des Kompensators 7 verhindert, solange ein Innendruck in dem Kompensator 7 einen Druckschwellenwert nicht überschreitet, und ein Entfalten des Faltenbalgs 9 freigibt, wenn der Innendruck in dem Kompensator 7 den Druckschwellenwert überschreitet. Die in den Figuren 10 bis 16 dargestellten Ausführungsbeispiele unterscheiden sich im Wesentlichen nur durch die Ausbildung der Rückhalte- und Freigabevorrichtung 51 voneinander.

Die Figuren 10 und 11 zeigen ein Ausführungsbeispiel, bei dem der zweite Kompensatorflansch 13 des Kompensators 7 wie in dem in Figur 1 dargestellten Ausführungsbeispiel eine Kesselöffnung 15 verschließend an dem Kesseldeckel 17 befestigt ist. Die Rückhalte- und Freigabevorrichtung 51 umfasst wenigstens ein Rückhalteelement 53, das an der Oberseite des als Blindflansch ausgebildeten ersten Kompensatorflansches 11 anliegt und durch wenigstens ein Verbindungselement 55 mit dem Kesseldeckel 17 verbunden ist. Jedes Verbindungselement 55 weist eine Sollbruchstelle 57 auf, die derartig ausgelegt ist, dass das Verbindungselement 55 an der Sollbruchstelle 57 auseinander bricht, wenn der Innendruck in dem Kompensator 7 den Druckschwellenwert überschreitet. Figur 10 zeigt das Gehäuse 1 in einem Nennbetrieb, in dem der Innendruck in dem Kompensator 7 den Druckschwellenwert nicht überschreitet und ein Entfalten des Faltenbalgs 9 von der Rückhalte- und Freigabevorrichtung 51 verhindert wird. Figur 11 zeigt die Rückhalte- und Freigabevorrichtung 51 nach dem Zerbrechen der Verbindungselemente 55 und Entfalten des Faltenbalgs 9. Da der Kompensator 7 in diesem Ausführungsbeispiel nur zur Kompensation von durch Lichtbögen verursachten Druckanstiegen in dem Kessel 3 dient, weist das Gehäuse 1 zur Kompensation von Druckanstiegen im Nennbetrieb ein herkömmliches Ausdehnungsgefäß 59 auf, das durch ein Verbindungsrohr 61 mit dem Kessel 3 verbunden ist. Statt eines herkömmlichen Ausdehnungsgefäßes 59 kann zur Kompensation von Druckanstiegen im Nennbetrieb natürlich auch wenigstens ein weiterer Kompensator 7 mit dem Kessel 3 verbunden sein.

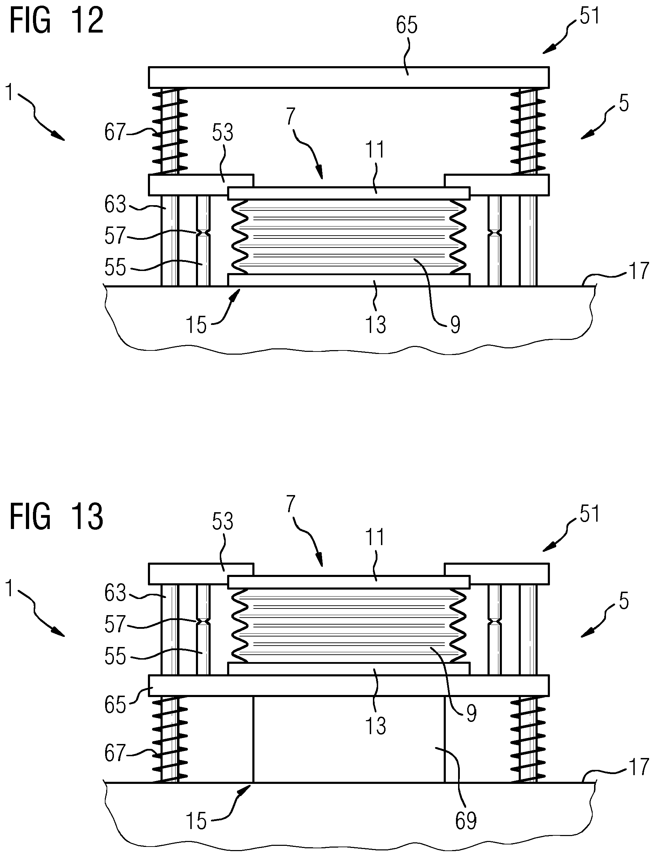

Figur 12 zeigt eine Weitergestaltung des in den Figuren 10 und 11 dargestellten Ausführungsbeispiels. Bei dieser Weitergestaltung weist die Rückhalte- und Freigabevorrichtung 51 zusätzlich auf dem Kesseldeckel 17 um den Kompensator 7 herum angeordnete Führungsstützen 63 auf, die miteinander oberhalb des Kompensators 7 durch ein Stützenverbindungselement 65 miteinander verbunden sind und von denen jeweils ein Rückhalteelement 53 geführt wird. Beispielsweise ist jede Führungsstütze 63 dazu stabförmig ausgebildet und durch eine Öffnung in einem Rückhalteelement 53 geführt. Zwischen dem Stützenverbindungselement 65 und dem jeweiligen Rückhalteelement 53 ist ferner an jeder Führungsstütze 63 eine Dämpfungsfeder 67 angeordnet, die durch das Entfalten des Faltenbalgs 9 nach dem Zerbrechen der Verbindungselemente 55 zusammengedrückt wird, so dass sie dem Entfalten des Faltenbalgs 9 entgegenwirkt und dieses dämpft, um eine stoßartige Belastung der Verankerung des Kompensators 7 zu reduzieren und eine Überdehnung des Kompensators 7 zu verhindern.

Figur 13 zeigt eine zu Figur 12 alternative Weitergestaltung des in den Figuren 10 und 11 dargestellten Ausführungsbeispiels. Auch bei dieser Weitergestaltung weist die Rückhalte- und Freigabevorrichtung 51 zusätzlich auf dem Kesseldeckel 17 um den Kompensator 7 herum angeordnete Führungsstützen 63 auf. Im Unterschied zu Figur 12 ist jede Führungsstütze 63 fest mit einem Rückhalteelement 53 verbunden, und ein plattenartiges Stützenverbindungselement 65 ist unterhalb des Kompensators 7 an dessen zweitem Kompensatorflansch 13 angeordnet, so dass der Kompensator 7 nicht an dem Kesseldeckel 17 sondern an dem Stützenverbindungselement 65 anliegt. An dem Stützenverbindungselement 65 ist kesselseitig ein Verbindungsrohr 69 angeordnet, das sich von dem Stützenverbindungselement 65 bis zu dem Kesseldeckel 17 erstreckt, dort die Kesselöffnung 15 umgibt und relativ zu dem Kesseldeckel 17 in vertikaler Richtung beweglich ist. Das Stützenverbindungselement 65 weist eine Verbindungsöffnung auf, die das Rohrinnere des Verbindungsrohres 69 mit dem Kompensatorinneren verbindet, so dass Isolierflüssigkeit aus dem Kesselinneren durch das Verbindungsrohr 69 in das Kompensatorinnere strömen kann. Die Verbindungselemente 55 mit den Sollbruchstellen 57 verbinden jeweils ein Rückhalteelement 53 mit dem Stützenverbindungselement 65. Die Führungsstützen 63 führen das Stützenverbindungselement 65. Beispielsweise ist jede Führungsstütze 63 dazu stabförmig ausgebildet und durch eine Führungsöffnung in dem Stützenverbindungselement 65 geführt. Die Sollbruchstellen 57 sind derartig ausgelegt, dass die Verbindungselemente 55 an den Sollbruchstellen 57 auseinander brechen, wenn der Innendruck in dem Kompensator 7 den Druckschwellenwert überschreitet. Nach dem Zerbrechen der Verbindungselemente 55 entfaltet sich der Faltenbalg 9 aufgrund des Innendrucks in dem Kompensator 7 nach unten, so dass sich das Stützenverbindungselement 65 an den Führungsstützen 63 geführt auf den Kesseldeckel 17 zu bewegt und das Verbindungsrohr 69 in das Kesselinnere hinein geschoben wird. Zwischen dem Stützenverbindungselement 65 und dem Kesseldeckel 17 ist an jeder Führungsstütze 63 eine Dämpfungsfeder 67 angeordnet, die durch das Entfalten des Faltenbalgs 9 nach dem Zerbrechen der Verbindungselemente 55 zusammengedrückt wird, so dass sie dem Entfalten des Faltenbalgs 9 entgegenwirkt und dieses dämpft.

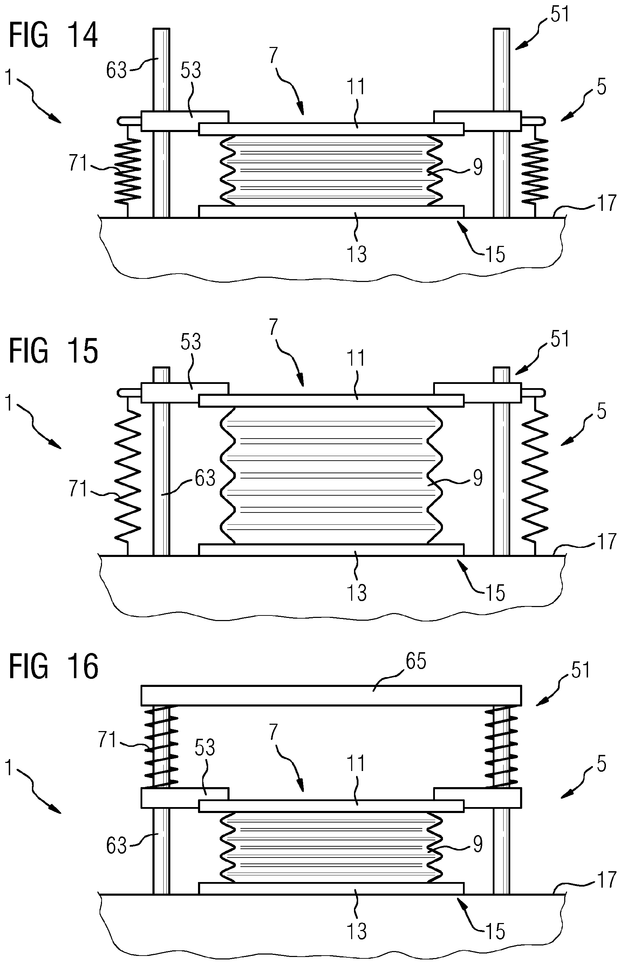

Die Figuren 14 und 15 zeigen ein Ausführungsbeispiel, bei dem der zweite Kompensatorflansch 13 des Kompensators 7 wie in dem in Figur 1 dargestellten Ausführungsbeispiel eine Kesselöffnung 15 verschließend an dem Kesseldeckel 17 befestigt ist. Die Rückhalte- und Freigabevorrichtung 51 umfasst wenigstens ein Rückhalteelement 53, das an der Oberseite des als Blindflansch ausgebildeten ersten Kompensatorflansches 11 anliegt. Ferner weist die Rückhalte- und Freigabevorrichtung 51 auf dem Kesseldeckel 17 um den Kompensator 7 herum angeordnete Führungsstützen 63 auf, von denen jeweils ein Rückhalteelement 53 geführt wird. Beispielsweise ist jede Führungsstütze 63 dazu stabförmig ausgebildet und durch eine Öffnung in einem Rückhalteelement 53 geführt. Zwischen dem Kesseldeckel 17 und dem jeweiligen Rückhalteelement 53 ist entlang jeder Führungsstütze 63 eine vorgespannte Vorspannfeder 71 angeordnet. Die Vorspannungen der Vorspannfedern 71 verhindern ein Entfalten des Faltenbalgs 9, solange ein Innendruck in dem Kompensator 7 einen Druckschwellenwert nicht überschreitet. Diese Situation ist in Figur 14 dargestellt. Nach dem Überschreiten des Druckschwellenwertes entfaltet sich der Faltenbalg 9 nach oben, wie in Figur 15 dargestellt ist.

Figur 16 zeigt ein weiteres Ausführungsbeispiel, das sich von dem in den Figuren 14 und 15 dargestellten Ausführungsbeispiel lediglich dadurch unterscheidet, dass die Führungsstützen 63 oberhalb des Kompensators 7 durch ein Stützenverbindungselement 65 miteinander verbunden sind und die Vorspannfedern 71 jeweils oberhalb des Kompensators 7 zwischen dem Stützenverbindungselement 65 und einem Rückhalteelement 53 an einer Führungsstütze 63 angeordnet sind.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Insbesondere kann eine Aufnahmevorrichtung 5 mehrere Kompensatoren 7 der in den Figuren 4 bis 9 dargestellten Art mit jeweils einem Verdrängungsbehälter 29 und/oder mehrere Kompensatoren 7 eines oder mehrerer der in den Figuren 10 bis 16 dargestellten Ausführungsbeispiele mit jeweils einer Rückhalte- und Freigabevorrichtung 51 aufweisen. Dabei können die Kompensatoren 7 verschiedene Härtegrade aufweisen und/oder die Rückhalte- und Freigabevorrichtungen 51 können für unterschiedliche Druckschwellenwerte ausgelegte Sollbruchstellen 57 bzw. Vorspannfedern 71 mit unterschiedlichen Federkonstanten und/oder Vorspannungen aufweisen, um unterschiedliche Druckanstiege in dem Kessel 3 zu kompensieren.

## Patentansprüche

1. Aufnahmevorrichtung (5) zur Aufnahme von Isolierflüssigkeit aus einem Kessel (3) eines Transformators oder einer Drossel, umfassend einen Kompensator (7), der als ein Hohlkörper mit einem veränderbaren Kompensatorvolumen ausgebildet ist und mit einer Kesselöffnung (15) des Kessels (3) verbindbar ist, so dass durch die Kesselöffnung (15) Isolierflüssigkeit zwischen einem Kesselinneren des Kessels (3) und dem Kompensatorvolumen strömen kann, wobei die Aufnahmevorrichtung ferner einen Verdrängungsbehälter (29) umfasst, der im Innern des Kompensators (7) und gegenüber dem Kompensator (7) hermetisch verschlossen angeordnet ist, **gekennzeichnet dadurch, dass** der Verdrängungsbehälter (29) einen Verdrängungsbehälterflansch (31) aufweist, der dazu ausgebildet ist, den Verdrängungsbehälter (29) wahlweise eine Kompensatoröffnung (43) verschließend an dem Kompensator (7) lösbar zu befestigen oder, anstatt des Kompensators (7), die Kesselöffnung (15) verschließend an dem Kessel (3) lösbar zu befestigen, so dass im letzten Fall durch die Kesselöffnung (15) Isolierflüssigkeit zwischen dem Kesselinneren und dem Inneren des Verdrängungsbehälters (29) strömen kann.

2. Aufnahmevorrichtung (5) nach Anspruch 1,
**dadurch gekennzeichnet, dass** der Verdrängungsbehälter (29) als ein Ausdehnungsgefäß zur Aufnahme von Isolierflüssigkeit durch die Kesselöffnung (15) aus dem Kesselinneren ausgebildet ist.

3. Aufnahmevorrichtung (5) nach Anspruch 2,
**dadurch gekennzeichnet, dass** in dem Verdrängungsbehälter (29) ein Gasbehälter (33) mit einem veränderbaren Gasbehältervolumen angeordnet ist, und dass der Verdrängungsbehälter (29) eine verschließbare Gasöffnung (35) zu dem Gasbehältervolumen aufweist, so dass bei geöffneter Gasöffnung (35) Gas zwischen dem Gasbehältervolumen und der Umgebung des Kessels (3) strömen kann, wenn der Verdrängungsbehälter (29) mit der Kesselöffnung (15) verbunden ist.

4. Aufnahmevorrichtung (5) nach Anspruch 3,
**dadurch gekennzeichnet, dass** der Gasbehälter (33) als ein Gummisack ausgebildet ist.

5. Aufnahmevorrichtung (5) nach einem der vorhergehenden Ansprüche,
**dadurch gekennzeichnet, dass** der Verdrängungsbehälter (29) einen Buchholzrelaisanschluss (39) für ein Buchholzrelais (41) aufweist.

6. Aufnahmevorrichtung (5) nach einem der vorhergehenden Ansprüche,
**dadurch gekennzeichnet, dass** der Verdrängungsbehälter (29) als ein topfähnlicher Hohlkörper ausgebildet ist.

7. Aufnahmevorrichtung (5) nach einem der vorhergehenden Ansprüche,
**dadurch gekennzeichnet, dass** der Verdrängungsbehälter (29) aus einem metallischen Werkstoff gefertigt ist.

8. Aufnahmevorrichtung (5) nach einem der vorhergehenden Ansprüche,
**dadurch gekennzeichnet, dass** der Kompensator (7) einen ersten Kompensatorflansch (11) aufweist, an dem der Verdrängungsbehälterflansch (31) die Kompensatoröffnung (43) verschließend lösbar befestigbar ist.

9. Aufnahmevorrichtung (5) nach Anspruch 8,
**dadurch gekennzeichnet, dass** der Kompensator (7) einen zweiten Kompensatorflansch (13) aufweist, der dazu ausgebildet ist, den Kompensator (7) die Kesselöffnung (15) des Kessels (3) verschließend lösbar an dem Kessel (3) zu befestigen.

10. Aufnahmevorrichtung (5) nach Anspruch 9,
**dadurch gekennzeichnet, dass** der Kompensator (7) zur Ausbildung des veränderbaren Kompensatorvolumens einen Faltenbalg (9) aufweist.

11. Aufnahmevorrichtung (5) nach Anspruch 10, **gekennzeichnet durch** wenigstens zwei genannte Kompensatoren (7), die sich hinsichtlich des Härtegrades ihrer Faltenbälge (9) voneinander unterscheiden.

12. Gehäuse (1) eines Transformators oder einer Drossel, das Gehäuse (1) umfassend einen Kessel (3) mit einer Kesselöffnung (15) und eine Aufnahmevorrichtung (5) gemäß einem der vorhergehenden Ansprüche.

## Claims

1. Take-up device (5) for taking up insulating fluid from a tank (3) of a transformer or a reactor, comprising a compensator (7), which is in the form of a hollow body with a variable compensator volume, and is able to be connected to a tank opening (15) of the tank (3), with the result that insulating fluid can flow through the tank opening (15) between a tank interior of the tank (3) and the compensator volume, wherein the take-up device furthermore comprises a displacement container (29), which is arranged in the interior of the compensator (7) and so as to be hermetically sealed with respect to the compensator (7),
**characterized in that** the displacement container (29) has a displacement container flange (31), which is designed to selectively detachably fasten the displacement container (29) to the compensator (7) so as to close off a compensator opening (43) or, instead of the compensator (7), to the tank (3) so as to close off the tank opening (15), with the result that, in the latter case, insulating fluid can flow through the tank opening (15) between the tank interior and the interior of the displacement container (29).

2. Take-up device (5) according to Claim 1,
**characterized in that** the displacement container (29) is in the form of an expansion vessel for taking up insulating fluid from the tank interior through the tank opening (15).

3. Take-up device (5) according to Claim 2,
**characterized in that** a gas container (33) with a variable gas container volume is arranged in the displacement container (29), and **in that** the displacement container (29) has a closable gas opening (35) to the gas container volume, with the result that, when the gas opening (35) is open, gas can flow between the gas container volume and the surroundings of the tank (3) if the displacement container (29) is connected to the tank opening (15).

4. Take-up device (5) according to Claim 3,
**characterized in that** the gas container (33) is in the form of a rubber bag.

5. Take-up device (5) according to one of the preceding claims,
**characterized in that** the displacement container (29) has a Buchholz relay connection (39) for a Buchholz relay (41).

6. Take-up device (5) according to one of the preceding claims,
**characterized in that** the displacement container (29) is in the form of a pot-like hollow body.

7. Take-up device (5) according to one of the preceding claims,
**characterized in that** the displacement container (29) is manufactured from a metallic material.

8. Take-up device (5) according to one of the preceding claims,
**characterized in that** the compensator (7) has a first compensator flange (11), to which the displacement container flange (31) is able to be detachably fastened so as to close off the compensator opening (43).

9. Take-up device (5) according to Claim 8,
**characterized in that** the compensator (7) has a second compensator flange (13), which is designed to detachably fasten the compensator (7) to the tank (3) so as to close off the tank opening (15) of the tank (3).

10. Take-up device (5) according to Claim 9,
**characterized in that** the compensator (7) has a corrugated bellows (9) for forming the variable compensator volume.

11. Take-up device (5) according to Claim 10,
**characterized by** at least two compensators (7) specified above, which differ from one another with regard to the degree of hardness of their corrugated bellows (9).

12. Housing (1) of a transformer or a reactor, the housing (1) comprising a tank (3) with a tank opening (15) and a take-up device (5) according to one of the preceding claims.

## Revendications

1. Dispositif (5) de réception pour recevoir du liquide isolant d'une cuve (3) d'un transformateur ou d'une bobine de self, comprenant un compensateur (7), qui est constitué en corps creux ayant un volume de compensateur variable et qui peut communiquer avec une ouverture (15) de la cuve (3), de manière à ce que du liquide isolant puisse, par l'ouverture (15) de la cuve, passer entre l'intérieur de la cuve (3) et le volume du compensateur,
dans lequel le dispositif de réception comprend, en outre, un récipient (29) de refoulement, qui est disposé à l'intérieur du compensateur (7) et en étant fermé de manière hermétique par rapport au compensateur (7),
**caractérisé en ce que** le récipient (29) de refoulement a une bride (31) de récipient de refoulement constituée pour, au choix, fixer de manière amovible le récipient (29) de refoulement au compensateur (7) en fermant une ouverture (43) du compensateur ou, au lieu de le fixer au compensateur (7), le fixer de manière amovible à la cuve (3) en fermant l'ouverture (15) de la cuve, de sorte que, dans le dernier cas, du liquide isolant peut passer par l'ouverture (15) de la cuve entre l'intérieur de la cuve et l'intérieur du récipient (29) de refoulement.

2. Dispositif (5) de réception suivant la revendication 1,
**caractérisé en ce que** le récipient (29) de refoulement est constitué sous la forme d'un vase d'expansion pour recevoir, par l'ouverture (15) de la cuve, du liquide isolant de l'intérieur de la cuve.

3. Dispositif (5) de réception suivant la revendication 2,
**caractérisé en ce que**, dans le récipient (29) de refoulement, est disposé un récipient (33) à gaz ayant un volume variable et **en ce que** le récipient (29) de refoulement a une ouverture (35) de gaz pouvant être fermée et par rapport au volume du récipient à gaz, de manière à ce que, lorsque l'ouverture (35) de gaz est ouverte, du gaz puisse passer entre le volume du récipient à gaz et l'atmosphère environnante de la cuve (3), si le récipient (29) de refoulement communique avec l'ouverture (15) de la cuve.

4. Dispositif (5) de réception suivant la revendication 3,
**caractérisé en ce que** le récipient (33) à gaz est constitué sous la forme d'un sac en caoutchouc.

5. Dispositif (5) de réception suivant l'une des revendications précédentes,
**caractérisé en ce que** le récipient (29) de refoulement a un raccord (39) de relais de Buchholz pour un relais (41) de Buchholz.

6. Dispositif (5) de réception suivant l'une des revendications précédentes,
**caractérisé en ce que** le récipient (29) de refoulement est constitué sous la forme d'un corps creux analogue à un pot.

7. Dispositif (5) de réception suivant l'une des revendications précédentes,
**caractérisé en ce que** le récipient (29) de refoulement est en un matériau métallique.

8. Dispositif (5) de réception suivant l'une des revendications précédentes,
**caractérisé en ce que** le compensateur (7) a une première bride (11) de compensateur, à laquelle la bride (31) du récipient de refoulement peut être fixée de manière amovible en fermant l'ouverture (43) du compensateur.

9. Dispositif (5) de réception suivant la revendication 8,
**caractérisé en ce que** le compensateur (7) a une deuxième bride (13) de compensateur, qui est constituée pour fixer le compensateur (7) de manière amovible à la cuve (3) en fermant l'ouverture (15) de la cuve (3).

10. Dispositif (5) de réception suivant la revendication 9,
**caractérisé en ce que** le compensateur (7) a un soufflet (9) à plis pour constituer le volume variable de compensateur.

11. Dispositif (5) de réception suivant la revendication 10,
**caractérisé par** au moins deux dits compensateurs (7), qui se distinguent les uns des autres en ce qui concerne le degré de dureté de leur soufflet (9) à plis.

12. Enveloppe (1) d'un transformateur ou d'une bobine de self, l'enveloppe (1) comprenant une cuve (3) ayant une ouverture (15) de cuve et un dispositif (5) de réception suivant l'une des revendications précédentes.
